Europäisches Patentamt

European Patent Office

Office européen des brevets

(11) Veröffentlichungsnummer: **0 304 032 B1**

(12) **EUROPÄISCHE PATENTSCHRIFT**

(45) Veröffentlichungstag der Patentschrift: **27.01.93**

(21) Anmeldenummer: **88113350.8**

(22) Anmeldetag: **17.08.88**

(51) Int. Cl.⁵: **H01L 31/10**

(54) **Lichtsteuerbarer Thyristor.**

(30) Priorität: **20.08.87 DE 3727820**

(43) Veröffentlichungstag der Anmeldung:
**22.02.89 Patentblatt 89/08**

(45) Bekanntmachung des Hinweises auf die
Patenterteilung:
**27.01.93 Patentblatt 93/04**

(84) Benannte Vertragsstaaten:
**CH DE FR GB LI SE**

(56) Entgegenhaltungen:
**DE-A- 2 458 401**
**DE-A- 3 102 851**
**FR-A- 2 322 458**
**FR-A- 2 386 906**

**PATENT ABSTRACTS OF JAPAN, Band 7, Nr. 72 (E-166)[1217], 25. März 1983, Seite 127 E 166; & JP-A-58 3280 (TOKYO SHIBAURA DEN-KI K.K.) 10-01-1983**

(73) Patentinhaber: **SIEMENS AKTIENGESELL-SCHAFT**
**Wittelsbacherplatz 2**
**W-8000 München 2(DE)**

(72) Erfinder: **Voss, Peter, Dr.-Ing.**
**Rudliebstrasse 42**
**W-8000 München 81(DE)**
Erfinder: **Wilhelmi, Wolf-Jens, Dipl.-Ing.**
**Fürstenfeldbrucker Strasse 16**
**W-8037 Olching(DE)**

**Beschreibung**

Die Erfindung bezieht sich auf einen lichtsteuerbaren Thyristor mit einem Halbleiterkörper mit den Merkmalen

a) der Halbleiterkörper hat einen lichtempfindlichen Bereich, eine Basiszone, eine Hilfsemitterzone und eine Hauptemitterzone,
b) die Hilfsemitterzone ist mit einer Hilfsemitterelektrode kontaktiert,
c) die Hilfsemitterelektrode kontaktiert einerseits die Hilfsemitterzone und andererseits die Basiszone auf der der Hauptemitterzone gegenüberliegenden Seite.

Ein solcher Thyristor ist z. B. in DE-A 27 15 482 oder in Patent Abstracts of Japan, Band 7, Nr. 72 (E-166)[1217], 25. März 1983 S. 127 E166 und JP-A-583 280 beschrieben worden. Die hauptsächlichen Anforderungen an einen lichtsteuerbaren Thyristor sind hohe Lichtempfindlichkeit bei gleichzeitig guter du/dt-Festigkeit. Die du/dt-Festigkeit wird im allgemeinen durch Emitter-Basisnebenschlüsse eingestellt. Bei durch Strom steuerbaren Thyristoren läßt sich diese Maßnahme sowohl beim Hilfsthyristor als auch beim Hauptthyristor anwenden.

Bei durch Licht steuerbaren Thyristoren ist im allgemeinen die angebotene Lichtleistung sehr gering, so daß die Emitter-Basisnebenschlüsse im Hilfsthyristor sehr schwach angelegt werden müssen und die du/dt-Festigkeit dementsprechend gering ist.

Ziel der Erfindung ist es, die du/dt-Festigkeit des Hilfsthyristors zu erhöhen, ohne die Lichtleistung wesentlich steigern zu müssen.

Dieses Ziel wird gemäß einer ersten Alternative erreicht durch eine zwischen dem lichtempfindlichen Bereich und der Hilfsemitterzone angeordnete, die Basiszone kontaktierende Basiselektrode und durch einen Kondensator, der zwischen der Basiselektrode und der Hilfsemitterelektrode angeschlossen ist.

Gemäß einer zweiten Alternative wird dieses Ziel dadurch erreicht, daß der lichtempfindliche Bereich von der Hilfsemitterzone überdeckt ist, daß die Hilfsemitterelektrode und die Basiselektrode streifenförmig ausgebildet und bezüglich der Hilfsemitterzone radial angeordnet sind und daß der lichtempfindliche Bereich (3) von der Hilfsemitterzone (14) überdeckt ist, daß die Hilfsemitterelektrode (17) und die Basiselektrode streifenförmig ausgebildet und bezüglich der Hilfsemitterzone (14) radial angeordnet sind und daß ein Kondensator (c) zwischen der Basiselektrode und der Hilfsemitterelektrode angeschlossen ist.

Die Erfindung wird anhand von Ausführungsbeispielen in Verbindung mit den Figuren 1 bis 6 näher erläutert. Es zeigen.

Figur 1 und 2 den Schnitt und die Aufsicht auf ein erstes Ausführungsbeispiel,
Figur 3 und 4 den Schnitt und die Aufsicht auf ein zweites Ausführungsbeispiel,
Figur 5 und 6 den Schnitt und die Aufsicht auf ein drittes Ausführungsbeispiel.

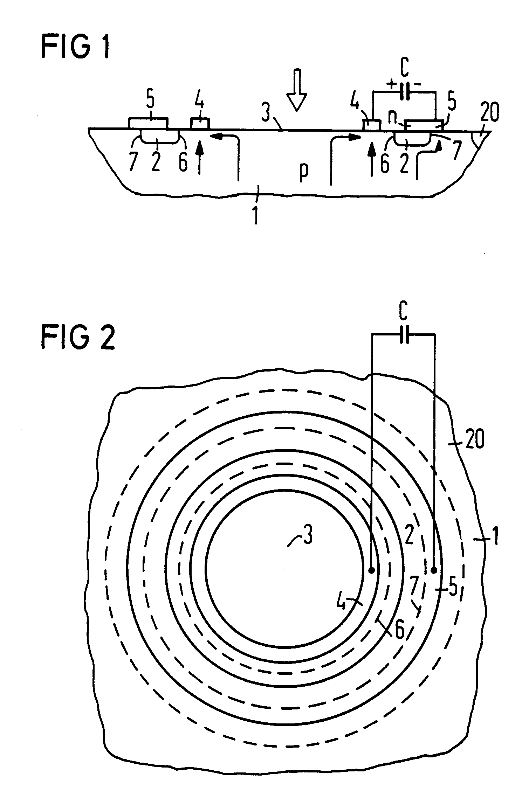

In den Figuren 1 und 2 ist ein Halbleiterkörper dargestellt, dessen katodenseitige Basiszone mit 1 bezeichnet ist. Sie ist beispielsweise p-dotiert. In die Oberfläche der Basiszone 1 ist eine Hilfsemitterzone 2 eingebettet. Die Hilfsemitterzone 2 ist ein Kreisring, der einen lichtempfindlichen Bereich 3 einschließt. Unter lichtempfindlichem Bereich wird bei diesem und den folgenden Ausführungsbeispielen derjenige Bereich verstanden, der zum Lichteinfall bestimmt ist. Das einfallende Licht ist durch einen dicken Pfeil gekennzeichnet.

Die Hilfsemitterzone 2 hat einen pn-Übergang, dessen an den lichtempfindlichen Bereich 3 angrenzender Innenrand mit 6 bezeichnet ist. Sein vom lichtempfindlichen Bereich abgewandter Rand ist mit 7 bezeichnet. Angrenzend an den lichtempfindlichen Breich 3 liegt auf der Basiszone 1 eine Basiselektrode 4, die nur die Basiszone 1 kontaktiert und den lichtempfindlichen Bereich 3 umschließt. Die Basiselektrode 4 ist beispielsweise ebenfalls ringförmig aufgebildet. Die Hilfsemitterzone 2 ist mit einer Hilfsemitterelektrode 5 verbunden, die ebenfalls ringförmig ist. Die Hilfsemitterelektrode 5 kontaktiert die Hilfsemitterzone 2 und die Basiszone 1 auf der der Emitterzone 20 des Hauptthyristors zugewandten Seite. Der Außenrand 7 der Hilfsemitterzone 2 ist damit kurzgeschlossen. Zwischen den Elektroden 4 und 5 ist ein Kondensator C angeschlossen. Der Kondensator überbrückt also die Hilfsemitterzone 2 in Richtung vom lichtempfindlichen Bereich 3 zur Hauptemitterzone 20.

Ein am Thyristor in Blockierrichtung anliegender Spannungsstrom erzeugt einen Verschiebungsstrom, der aus dem Inneren des Halbleiterkörpers zur Kathodenseite fließt. Dieser Strom ist durch die dünnen aufwärts gerichteten Pfeile symbolisiert. Ein großer Teil dieses Stroms fließt über die Elektrode 4 in den Kondensator C und lädt diesen auf. Ein geringerer Teil des Verschiebungsstroms fließt radial unter der Hilfsemitterzone 2 nach außen zur Elektrode 5 ab. Der zur Elektrode 5 abfließende Strom spannt den Hilfsemitter vor. Dadurch, daß ein großer Teil des Verschiebungsstroms nicht radial unter dem Hilfsemitter zur Elektrode 5 fließt sondern in den Kondensator, kann der Verschiebungsstrom, d.h. das du/dt am Thyristor erhöht werden, ohne daß der Hilfsthyristor zündet.

Eine Abschätzung der Größe des Kondensators C ergibt sich aus der Überlegung, daß die maximal verschiebbare Ladung pro Flächeneinheit im Halbleiterkörper des Thyristors bei 1,6 x $10^{-7}$ As/cm$^2$ entsprechend $10^{12}$ Ladungsträger/cm$^2$ liegt. Die maximal mögliche Ladung pro Flächeneinheit ist dies deswegen, weil bei höherer Ladung die kritische Feldstärke erreicht und der Lawinendurchbruch einsetzen würde. Bei einem Radius des lichtempfindlichen Bereichs 3 von z.B. 0,7 mm ergibt sich damit eine Flächenladung von 2,5 x $10^{-9}$ As. Für die Kapazität ergibt sich, wenn der Kondensator auf 0,3 V aufgeladen werden soll somit

$$C = \frac{2,5 \times 10^{-9}}{0,3} = 8x \ 10^{-9} \ F = 8 \ nF$$

Der Kondensator C läßt sich am platzsparendsten in hybrider Form als auf einer Oberfläche montierbares Bauelement (SMD = surface mounted device) auf dem Halbleiterkörper des Thyristors aufbringen. Ein typischer Flächenbedarf eines Kondensators der obengenannten Kapazität ist 2,0 x 1,2 mm$^2$. Der Kondensator kann jedoch auch in integrierter Form. z.B. mit einem Oxid als Dielektrikum aufgebracht werden. In diesem Fall ist der Platzbedarf größer. Er liegt für die oben angegebene Kapazität von 8 nF bei rund 0,2 cm$^2$.

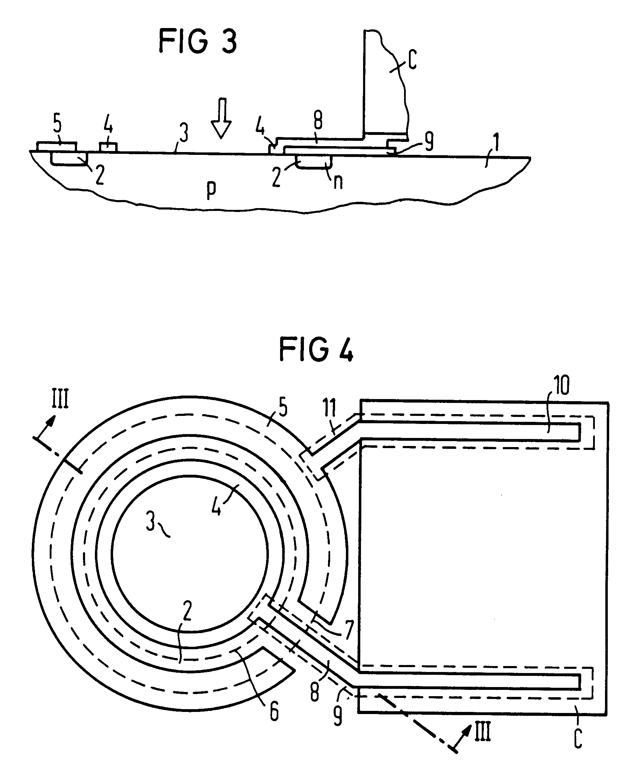

Ein Ausführungsbeispiel mit einem auf dem Thyristor integrierten Kondensator ist in den FIG 3 und 4 angegeben. Hierbei haben gleiche oder funktionsgleiche Teile wie in den FIG 1 und 2 gleiche Bezugszeichen. Die Basiselektrode 4 ist mit einer Leiterbahn 8 verbunden, die auf einer Oxidschicht 9 aufgebracht ist und in einer Lücke der Hilfsemitterelektrode 5 liegt. Die Oxidschicht 9, die auch eine andere Isolierschicht sein kann, isoliert die Leiterbahn 8 gegen die Hilfsemitterzone 2. Die Hilfsemitterelektrode 5 ist mit einem Kontaktfinger 10 verbunden, der ebenfalls auf einer Isolierschicht, z.B. einer Oxidschicht 11 angeordnet sein kann. Die Wirkungsweise ist die gleiche wie die in Verbindung mit den FIG 1 und 2 erwähnte.

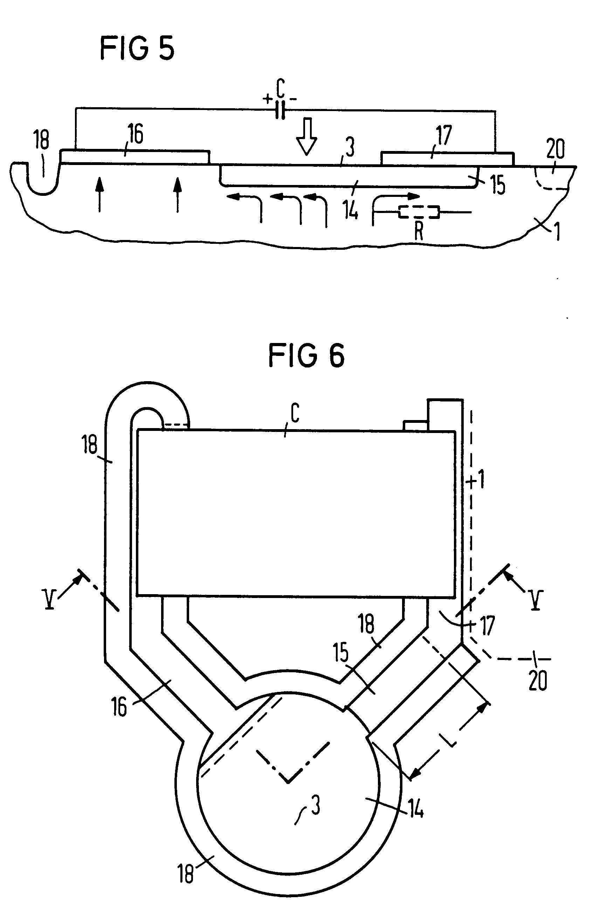

Die Ausführungsbeispiele nach den FIG 1 bis 4 sind dadurch charakterisiert, daß der lichtempfindliche Bereich die an der Oberfläche liegende Basiszone 1 ist. Der lichtempfindliche Bereich kann jedoch bekanntlich auch durch die Hilfsemitterzone abgedeckt sein. In FIG 5 und 6 ist ein solches Ausführungsbeispiel dargestellt. Die Hilfsemitterzone ist hier mit 14 bezeichnet, der lichtempfindliche Bereich wieder mit 3. Die Hilfsemitterzone 14 ist mit einer Hilfsemitterelektrode 17 versehen, die auch die Basiszone 1 kontaktiert. Die Basiszone 1 ist benachbart dem lichtempfindlichen Bereich 3 mit einer Basiselektrode 16 kontaktiert. An die Elektroden 16 und 17 ist der Kondensator C angeschlossen.

Ein aus dem Halbleiterkörper aufgrund einer du/dt-Belastung fließender Verschiebungsstrom erzeugt einen Strom, der durch die dünnen, aufwärts gerichteten Pfeile charakterisiert ist. Der größte Teil des Verschiebungsstroms fließt lateral unter der Emitterzone 14 bzw. direkt vertikal zur Elektrode 16. Damit wird der Kondensator in der angegebenen Polarität aufgeladen. Ein Bruchteil des Verschiebungsstroms fließt in der Basiszone lateral unter der Hilfsemitterzone 14 zur Hilfsemitterelektrode 17 und von dort zum Hauptthyristor ab. Sein Bahnwiderstand ist durch das gestrichelte Widerstandssymbol R bezeichnet.

Eine günstige Ausführungsform ist in FIG 6 dargestellt. Die FIG 5 ist ein Schnitt entlang der Linie V - V durch die FIG 6. Die Hilfsemitterzone 14 ist mit einem streifenförmigen Fortsatz 15 versehen, der sich radial zur Zone 14 erstreckt. Die Länge L dieses Fortsatzes bestimmt bei gegebener Breite die Größe von R. Der Fortsatz ist mit einer streifenförmigen Hilfsemitterelektrode 17 bedeckt. Sie kontaktiert auch die Basiszone 1 und liegt der Emitterzone 20 des Hauptemitters gegenüber. Die Basiselektrode 16 wird ebenfalls durch einen Leiterstreifen gebildet, der sich im wesentlichen ebenfalls radial zur Hilfsemitterzone 14 erstreckt. Die Streifen 16 und 17 sind dabei derart geformt, daß sich ein SMD-Kondensator montieren läßt. Sie können jedoch auch anders geformt sein. Grundsätzlich sollte die Fläche des Streifens 16 so klein wie möglich sein.

Um sicherzustellen, daß der Verschiebungsstrom in den Kondensator fließt und nicht entlang der relativ hoch dotierten Oberfläche der Basiszone 1 zur Hilfsemitterelektrode abfließt, ist der Kontakt 16 von einem Graben 18 umgeben. Der Graben 18 begrenzt zweckmäßigerweise auch die Hilfsemitterzone 14 und die Längsseiten des Fortsatzes 15. Damit wird der unter der Zone 14 in der Raumladungszone erzeugte Fotostrom gezwungen, unter dem Fortsatz 15 zu fließen. Dort findet er einen relativ hohen Bahnwiderstand R vor. Dadurch erzeugt auch ein kleiner Fotostrom den zum Zünden notwendigen Spannungsabfall von etwa 0,5 V. Der Graben kann sich auch auf diejenige Seite der Hilfsemitterelektrode erstrecken, die der Basiselektrode 16 gegenüberliegt.

Für alle Ausführungsbeispiele gilt, daß die Lichtempfindlichkeit so lange herabgesetzt ist, bis der Kondensator C aufgeladen ist. Ist er aufgeladen, so besteht nur noch der durch die Hilfselektrode bewirkte Nebenschluß zwischen der Hilfsemitterzone 2 und der Basiszone 1.

**Patentansprüche**

1.  Lichtsteuerbarer Thyristor mit einem Halbleiterkörper mit den Merkmalen
    a) der Halbleiterkörper hat einen lichtempfindlichen Bereich (3), eine Basiszone (1), eine Hilfsemitterzone (2; 14) und eine Hauptemitterzone (20),
    b) die Hilfsemitterzone ist mit einer Hilfsemitterelektrode (5; 17) kontaktiert,
    c) die Hilfsemitterelektrode (5; 17) kontaktiert einerseits die Hilfsemitterzone (2) und andererseits die Basiszone (1) auf der der Hauptemitterzone (20) gegenüberliegenden Seite,
    **gekennzeichnet durch** eine zwischen dem lichtempfindlichen Bereich (3) und der Hilfsemitterzone (2) angeordnete, die Basiszone (1) kontaktierende Basiselektrode (4) und durch einen Kondensator (C), der zwischen der Basiselektrode (4) und der Hilfsemitterelektrode angeschlossen ist.

2.  Lichtsteuerbarer Thyristor nach Anspruch 1,
    **dadurch gekennzeichnet,** daß die Basiselektrode (4) und die Hilfsemitterzone (2) ringförmig ausgebildet sind und den lichtempfindlichen Bereich (3) umgeben.

3.  Lichtsteuerbarer Thyristor mit einem Halbleiterkörper mit den Merkmalen
    a) der Halbleiterkörper hat einen lichtempfindlichen Bereich (3), eine Basiszone (1), eine Hilfsemitterzone (2; 14) und eine Hauptemitterzone (20),
    b) die Hilfsemitterzone ist mit einer Hilfsemitterelektrode (5; 17) kontaktiert,
    c) die Hilfsemitterelektrode (5; 17) kontaktiert einerseits die Hilfsemitterzone (2) und andererseits die Basiszone (1) auf der der Hauptemitterzone (20) gegenüberliegenden Seite,
    **dadurch gekennzeichnet,** daß der lichtempfindliche Bereich (3) von der Hilfsemitterzone (14) überdeckt ist, daß die Hilfsemitterelektrode (17) und die Basiselektrode streifenförmig ausgebildet und bezüglich der Hilfsemitterzone (14) radial angeordnet sind und daß ein Kondensator (C) zwischen der Basiselektrode und der Hilfsemitterelektrode angeschlossen ist.

4.  Thyristor nach Anspruch 3,
    **dadurch gekennzeichnet,** daß die Hilfsemitterzone (14) einen streifenförmigen Fortsatz (15) hat, daß die Hilfsemitterzone, die Basiselektrode (16) und beide Längsseiten des Fortsatzes von einem in der Basiszone (1) liegenden Graben (18) umgeben ist, der tiefer ist als die Hilfsemitterzone.

5.  Thyristor nach einem der Ansprüche 1 bis 5,
    **dadurch gekennzeichnet,**
    daß der Kondensator (C) auf dem Halbleiterkörper befestigt ist.

6.  Thyristor nach Anspruch 5,
    **dadurch gekennzeichnet,**
    daß der Kondensator (C) ein auf einer Oberfläche montierbares Bauteil ist und mit seinen Anschlüssen unmittelbar auf der Hilfsemitterelektrode (17) und der Basiselektrode (16) befestigt ist.

7.  Thyristor nach Anspruch 5,
    **dadurch gekennzeichnet,**
    daß der Kondensator (C) auf der Oberfläche des Halbleiterkörpers integriert angeordnet ist.

**Claims**

1.  Light-controllable thyristor having a semiconductor body with the features:
    a) the semiconductor body has a photosensitive area (3), a base zone (1), an auxiliary emitter zone (2; 14) and a main emitter zone (20),
    b) the auxiliary emitter zone is in contact with an auxiliary emitter electrode (5; 17),
    c) the auxiliary emitter electrode (5; 17) is in contact, on the one hand, with the auxiliary emitter zone (2) and, on the other hand, the base zone (1) on the side situated opposite the main emitter zone (20),
    characterised by a base electrode (4) disposed between the photosensitive area (3) and the auxiliary emitter zone (2) and in contact with the base zone (1), and by a capacitor (C) connected between the base electrode (4) and the auxiliary emitter electrode.

2. Light-controllable thyristor according to Claim 1, characterised in that the base electrode (4) and the auxiliary emitter zone (2) are of annular construction and surround the photosensitive area (3).

3. Light-controllable thyristor having a semiconductor body with the features:
   a) the semiconductor body has a photosensitive area (3), a base zone (1), an auxiliary emitter zone (2; 14) and a main emitter zone (20),
   b) the auxiliary emitter zone is in contact with an auxiliary emitter electrode (5; 17),
   c) the auxiliary emitter electrode (5; 17) is in contact, on the one hand, with the auxiliary emitter zone (2) and, on the other hand, with the base zone (1) on the side situated opposite the main emitter zone (20),
   characterised in that the photosensitive area (3) is covered by the auxiliary emitter zone (14), in that the auxiliary emitter electrode (17) and the base electrode are of strip-type construction and are disposed radially with respect to the auxiliary emitter zone (14), and in that a capacitor (C) is connected between the base electrode and the auxiliary emitter electrode.

4. Thyristor according to Claim 3, characterised in that the auxiliary emitter zone (14) has a strip-type extension (15), and in that the auxiliary emitter zone, the base electrode (16) and both long sides of the extension are surrounded by a trench (18) situated in the base zone (1) and deeper than the auxiliary emitter zone.

5. Thyristor according to one of Claims 1 to 5, characterised in that the capacitor (C) is mounted on the semiconductor body.

6. Thyristor according to Claim 5, characterised in that the capacitor (C) is a surface-mountable component and is mounted directly on the auxiliary emitter electrode (17) and the base electrode (16) by means of its connections.

7. Thyristor according to Claim 5, characterised in that the capacitor (C) is disposed in integrated form on the surface of the semiconductor body.

**Revendications**

1. Thyristor commandable par la lumière et comportant un corps semiconducteur, présentant les particularités suivantes
   a) le corps semiconducteur possède une zone photosensible (3), une zone de base (1), une zone d'émetteur auxiliaire (2;14) et une zone d'émetteur principal (20),
   b) la zone d'émetteur auxiliaire est placée en contact avec une électrode d'émetteur auxiliaire (5;17),
   c) l'électrode d'émetteur auxiliaire (5;17) est placée en contact, d'une part, avec la zone d'émetteur auxiliaire (2), et, d'autre part, avec la zone de base (1) sur la face située à l'opposé de la zone d'émetteur principale (20),
   caractérisé par une électrode de base (4), qui est disposée entre la zone photosensible (3) et la zone d'émetteur auxiliaire (2) et établit un contact avec la zone de base (1), et par le condensateur (C), qui est branché entre l'électrode de base (4) et l'électrode d'émetteur auxiliaire.

2. Thyristor commandable par la lumière suivant la revendication 1, caractérisé par le fait que l'électrode de base (4) et la zone d'émetteur auxiliaire (2) possèdent une forme annulaire et entourent la zone photosensible (3).

3. Thyristor commandable par la lumière et comportant un corps semiconducteur, présentant les particularités suivantes
   a) le corps semiconducteur possède une zone photosensible (3), une zone de base (1), une zone d'émetteur auxiliaire (2;14) et une zone d'émetteur principal (20),
   b) la zone d'émetteur auxiliaire est placée en contact avec une électrode d'émetteur auxiliaire (5;17),
   c) l'électrode d'émetteur auxiliaire (5;17) est placée en contact, d'une part, avec la zone d'émetteur auxiliaire (2), et, d'autre part, avec la zone de base (1) sur la face située à l'opposé de la zone d'émetteur principale (20),
caractérisé par le fait que la zone photosensible (3) est recouverte par la zone d'émetteur auxiliaire (14), que l'électrode d'émetteur auxiliaire (17) et l'électrode de base sont agencées sous la forme de bandes et sont disposées radialement par rapport à la zone d'émetteur auxiliaire (14) et qu'un condensateur (C) est branché entre l'électrode de base et l'électrode d'émetteur auxiliaire.

4. Thyristor suivant la revendication 3, caractérisé par le fait que la zone d'émetteur auxiliaire (14) possède un prolongement en forme de bande (15), que la zone d'émetteur auxiliaire, l'électrode de base (16) et les deux côtés longitudinaux du prolongement sont entourés par un sillon (18) qui est situé dans la zone de base (1) et est plus profond que la zone d'émetteur auxiliaire.

5. Thyristor suivant l'une des revendications 1 à 5, caractérisé par le fait que le condensateur (C) est fixé sur le corps semiconducteur.

6. Thyristor suivant la revendication 5, caractérisé par le fait que le condensateur (C) est un composant pouvant être monté sur une surface et est fixé, par ses bornes, directement sur l'électrode d'émetteur auxiliaire (17) et sur l'électrode de base (7).

7. Thyristor suivant la revendication 5, caractérisé par le fait que le condensateur (C) est disposé de façon intégrée sur la surface du corps semiconducteur.

FIG 1

FIG 2

# FIG 3

# FIG 4

## FIG 5

## FIG 6